Europäisches Patentamt

European Patent Office

Office européen des brevets

(19)

(11) Publication number: **0 239 268**
**A2**

# (12) EUROPEAN PATENT APPLICATION

(21) Application number: **87301898.0**

(22) Date of filing: **05.03.87**

(51) Int. Cl.⁴: **G 01 R 31/08**, G 01 R 27/16

(30) Priority: **07.03.86 JP 50822/86**
**07.03.86 JP 50824/86**

(43) Date of publication of application: **30.09.87**
**Bulletin 87/40**

(84) Designated Contracting States: **DE FR GB**

(71) Applicant: **MITSUBISHI DENKI KABUSHIKI KAISHA, 2-3, Marunouchi 2-chome Chiyoda-ku, Tokyo 100 (JP)**

(72) Inventor: **Kotani, Genzaburou c/o Seigyo Seisakusho, Mitsubishi Denki K.K. 1-2, Wadasaki-Cho, 1-Chome, Hyogo-Ku Kobe-shi Hyogo-Ken (JP)**

(74) Representative: **Charlton, Peter John et al, Elkington and Fife High Holborn House 52/54 High Holborn, London WC1V 6SH (GB)**

(54) Fault point locating method, fault point resistance measuring method, and impedance to fault point measuring method, and apparatus therefor.

(57) This invention relates to a method for locating a fault point in a two-terminal system transmission line, a method for measuring impedance to the fault point at a three-terminal system transmission line, and methods for measuring the fault point therefor, and locators and measuring apparatus for putting these methods in practical use. It is utilized that, when a fault point current is made reference, the sine component of voltage at the apparatus installation point is equal to the sine component of impedance drop to the fault point therefrom, and that a phase difference between the component of current flowing in the fault point from the apparatus installation side end and that of a fault point current of the sum of the components of current flowing from the apparatus installation end and of current flowing from the other end to the fault point are substituted into the equation representing the above relation, thereby enabling the fault location, fault point resistance measurement and impedance measurement to the fault point to be measured without using the voltage and current data of the other end.

# FAULT POINT LOCATING METHOD, FAULT POINT RESISTANCE MEASURING METHOD, AND IMPEDANCE TO MEASURING METHOD, AND APPARATUSES THEREFOR

## BACKGROUND OF THE INVENTION

### Field of the Invention

The present invention relates to a fault point locating, and a fault point resistance measuring at a two terminal system transmission line, and to measuring of impedance from a local sending end to a fault point and a fault point resistance measuring at a three terminal system transmission line.

### Description of the Prior Art

The fault point locating method at the two terminal system transmission line is known as follows:

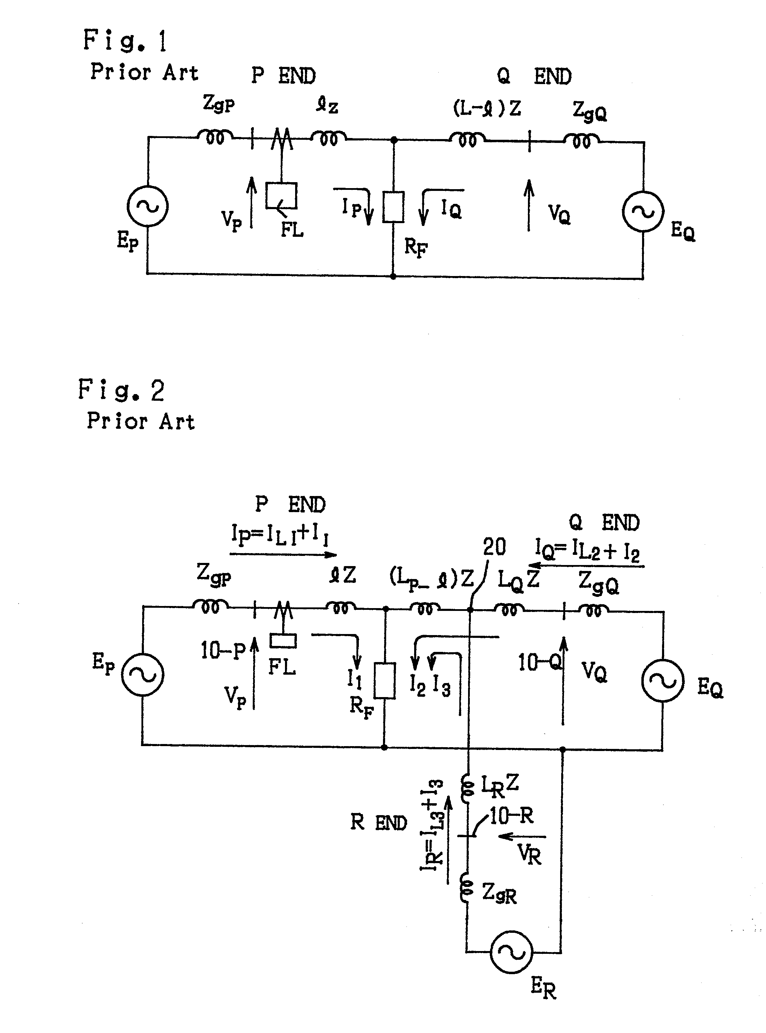

Referring to Fig. 1, an equivalent circuit when a fault occurs is shown, in which references $E_P$ and $E_Q$ designate supply voltages at one sending end P where a fault locator is provided and the other end Q, $Zg_P$ and $Zg_Q$ designate back impedance at the ends P and Q, $V_P$ and $V_Q$ designate voltages at the same, and $I_P$ and $I_Q$ designate currents flowing from the ends P and Q to the fault point respectively. $R_F$ designates fault resistance, $\ell Z$ designates impedance from the

1

## 2

fault locator FL installation point to the fault point, $\ell$ designates a distance between the fault locator FL installation point and the fault point, Z designates impedance per unit length of the transmission line, $(L-\ell)Z$ designates impedance from the fault point to the end Q, and L designates a distance between the ends P and Q.

Paying attention to a circuit at the P end side from the fault point resistance $R_F$, the following equation (1) should hold:

$$V_P = \ell Z I_P + R_F (I_P + I_Q) \cdot \cdot \cdot \cdot \cdot \cdot (1)$$

Accordingly, impedance to the fault point obtained from the voltage and current information at the end P at the fault locator installation point, that is, the local end, leads the following equation:

$$\frac{V_P}{I_P} = \ell Z + R_F (1 + \frac{I_Q}{I_P}) \cdot \cdot \cdot \cdot \cdot \cdot (2)$$

where the impedance $\ell Z$ to the fault point obtained when $R_F$ is zero is divided by the impedance Z per unit length of the transmission line, thereby enabling the distance $\ell$ to the fault point to be obtained. However, in an actual line, $R_F$ is not zero but an unknown value variable according to the fault condition, so that even when the current $I_Q$ at the other sending end Q is known, the distance $\ell$ cannot be computed with accuracy.

3

The Japanese Patent Publication No. 57-50262 (1982) discloses that the voltage and current data of the other end Q is used in order to solve the above problem. In other words, observing the circuit at the end Q side from the fault point resistance $R_F$, the following equation should hold:

$$V_Q = (L-\ell)ZI_Q + R_F(I_P + I_Q) \cdots\cdots (3)$$

From the equations (1) and (3), $\ell$ is given in the following equation:

$$\ell = \frac{V_P - V_Q + LZI_Q}{Z(I_P + I_Q)} \cdots\cdots (4)$$

The fault point can be located by computing the equation (4), but it is troublesome in practical use that the voltage and current data of the other sending end Q must be obtained.

The measuring of impedance to the fault point at a three terminal transmission line has the same problem as above. Referring to Fig. 2, an equivalent circuit when the fault occurs is shown.

In Fig. 2, references $E_P$, $E_Q$ and $E_R$ designate supply voltages for a sending end P where a fault locator FL is provided, and for other ends Q and R; $Zg_P$, $Zg_Q$ and $Zg_R$ designate back impedance at the ends P, Q and R respectively; 10 - P, 10 - Q and 10 - R designate buses at the ends P, Q

4

and R respectively; $V_P$, $V_Q$ and $V_R$ designate bus voltages at the ends P, Q and R; $I_P$, $I_Q$ and $I_R$ designate currents flowing in the ends P, Q and R when the system is in failure; $I_{L1}$, $I_{L2}$ and $I_{L3}$ designate load currents flowing in the ends P, Q and R when the system is normal; $I_1$, $I_2$ and $I_3$ designate incremental currents flowing into the fault point from the ends P, Q and R when the system is in failure. $R_F$ designates fault point resistance; 20 designates a junction of the three terminal system; $\ell Z$ designates impedance from the fault locator FL installation point to the fault point; $\ell$ designates a length between the fault locator FL installation point and the fault point, Z designates impedance per unit length of the transmission line; and $L_P$, $L_Q$ and $L_R$ designate distances from the buses at the ends P, Q and R to the junction 20 respectively.

Observing the circuit at the P end side from the fault point resistance $R_F$ in Fig. 2, the following equation (5) should hold:

$$V_P = \ell Z_P + R_F (I_1 + I_2 + I_3) \cdots \cdots (5)$$

Accordingly, the impedance to the fault point obtained from the voltage and current information at the end P at the fault locator FL side, that is, the local end, leads the following equation:

4

5

$$\frac{V_P}{I_P} = \ell Z + R_F \left(\frac{I_1 + I_2 + I_3}{I_P}\right) \cdots \cdots (6)$$

where the impedance $\ell Z$ to the fault point can be obtained when $R_F$ is zero, but $R_F$, when the fault occurs, is an unknown value variable by the fault condition and is unknown, so that even when $I_2$ and $I_3$ are obtained, two terms in the equation (6) will produce an error.

The Japanese Patent Publication No. 58-21493 (1983), in order to solve the above problem, discloses the use of the voltage and current data of other ends Q and R. In other words, observing the circuit from the fault point resistance $R_F$ to the ends Q and R, the following equations (7) and (8) should hold:

$$V_P - \ell Z I_P = V_Q - I_Q Z I_Q - (I_P - \ell) Z (I_Q + I_R) \cdots \cdots (7)$$

$$V_P - \ell Z I_P = V_R - I_R Z I_R - (I_P - \ell) Z (I_Q + I_R) \cdots \cdots (8)$$

When the equations (7) and (8) are added with each other and divided by 2, the following equation (9) should hold:

$$V_P - \ell Z I_P = \frac{1}{2} (V_Q + V_R - I_Q Z I_Q - I_R Z I_R) - (I_P - \ell) Z (I_Q + I_R)$$
$$\cdots \cdots (9)$$

From the equation (9), the impedance $\ell Z$ to the fault point is given in the following equation:

$$\ell Z = \frac{2V_P - V_Q - V_R}{2(I_P + I_Q + I_R)} + \frac{I_Q Z I_Q + I_R Z I_R + 2I_P Z (I_Q + I_R)}{2(I_P + I_Q + I_R)}$$

$$= \frac{3V_P - V_P - V_Q - V_R}{2(I_P + I_Q + I_R)} + L_P Z + \frac{I_Q Z I_Q + I_R Z I_R + L_P Z I_P - 3L_P Z I_P}{2(I_P + I_Q + I_R)}$$

$$= L_P Z + \frac{3}{2} \cdot \frac{V_P - L_P Z I_P}{I_P + I_Q + I_R} - \frac{1}{2} \cdot \frac{V_P + V_Q + V_R - I_P Z I_P - I_Q Z I_Q - I_R Z I_R}{I_P + I_Q + I_R}$$

$$\cdots \cdots (10)$$

Thus, since the impedance $\ell Z$ is obtained from the equation (10), the voltage and current data of other ends Q and R must be know.


SUMMARY OF THE INVENTION

In order to solve the above problem in the prior art, the present invention has been designed. Paying attention to that, when the fault point current is assumed as a reference value, the sine wave component of voltage at the fault locator FL installation point is equal to that of impedance drop to the fault point the present invention substitutes into the equation representing the above relation a phase difference between the component of current flowing to the fault point form the end at the fault locator FL installation side and a fault point current of said current component added with the component of a current flowing to the fault point from the other sending end, thereby enabling the fault location, impedance measuring or fault point resistance measuring without using the voltage and current data of

6

7

the other end.

A first object of this invention is to provide a fault point locating method and a fault locator which can instantaneously locate the fault point in a two terminal system transmission line without using the voltage and current information of the other end.

A second object of this invention is to provide a fault point locating method and a fault locator in the two termical system transmission line, which is free from an error in distance measurement caused by the fault point resistance and not affected by the load current.

A third object of this invention is to provide a method and an apparatus therefor in a three terminal system transmission line, which can instantaneously measure impedance to the fault point without using the voltage and current information of the other end.

A forth object of this invention is to provide a method and an apparatus therefor in a three terminal system transmission line, which is free from an error in distance measurement caused by the fault point resistance and not affected by the load current.

A fifth object of this invention is to provide a method and an apparatus therefor which can instantaneously measure the fault point resistance without using the voltage and

8

current data of the other end in a two or three terminal system transmission line.

The above and further objects and features of the invention will more fully be apparent from the following detailed description with accompanying drawings.

BRIEF DESCRIPTION OF THE DRAWINGS

Fig. 1 is an equivalent circuit diagram explanatory of the conventional fault point locating method at a two terminal system transmission line;

Fig. 2 is an equivalent circuit diagram explanatory of the conventional method of measuring impedance to the fault point at a three terminal system transmission line;

Fig. 3 is an equivalent circuit diagram explanatory of a fault point locating method of the invention,

Figs. 4 and 5 are vector diagrams explanatory of the fault point locating method of the present invention, which show the phase relationship between the voltage and the current at the respective sending ends;

Fig. 6 is an equivalent circuit diagram explanatory of the fault point locating method of the invention;

Figs. 7 and 8 are equivalent circuit diagrams explanatory of a method of measuring impedance to the fault point in the invention;

9

Fig. 9 is an equivalent circuit diagram when no fault occurs;

Figs. 10-(a), (b) and (c) are equivalent circuit diagrams explanatory of impedance to the fault point in the invention, and

Fig. 11 is a vector diagram showing the voltage and current components shown in Fig. 7.


DESCRIPTION OF THE PREFERRED EMBODIMENTS

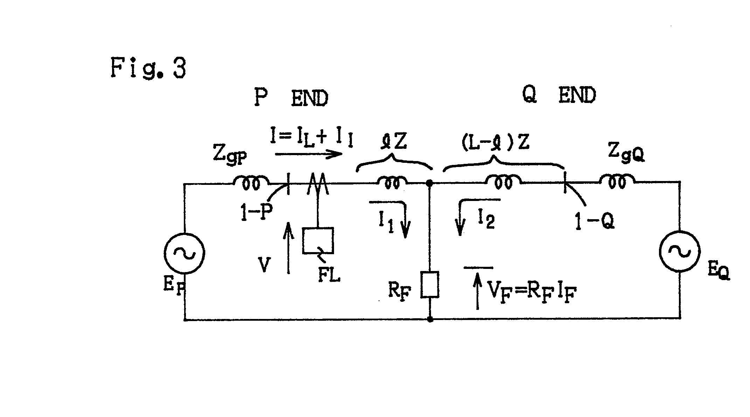

Fig. 3 shows an equivalent circuit in a two terminal system transmission line in the same as that in Fig. 1, in which the same components as those in Fig. 1 are designated by the same references except that $V_P$ in Fig. 1 is designated by V in Fig. 3.   In Fig. 3, references $E_P$ and $E_Q$ designate supply voltages at the sending ends P and Q respectively, $Zg_P$ and $Zg_Q$ designate back impedance at the ends P and Q respectively, 1-P, 1-Q designate buses at the ends P and Q respectively, V designates voltage when a fault occurs, FL designates a fault locator, $\ell Z$ designates impedance to the fault point, $\ell$ designates a distance to the fault point, Z designates impedance per unit length of the transmission line, $(L-\ell)Z$ designates impedance from the fault point to the bus at the end Q, L designates a distance between the bus at the end P and that the the end Q $R_F$ designates fault point resistance produced when the fault occurs,
I designates a current flowing in the fault locator installation point when the fault occurs, and the sum of a load
current $I_L$ flowing in the system when normal and an incre-
mental current $I_1$ flowing from the end P to the fault point
when the fault occurs, $I_2$ designates an incremental current
flowing from the end Q to the fault point when the fault occurs, and $V_F$ designates voltage at the fault point and represents a voltage drop $R_F I_F$ created at a fault point resist-
ance, where $I_F = I_1 + I_2$ .

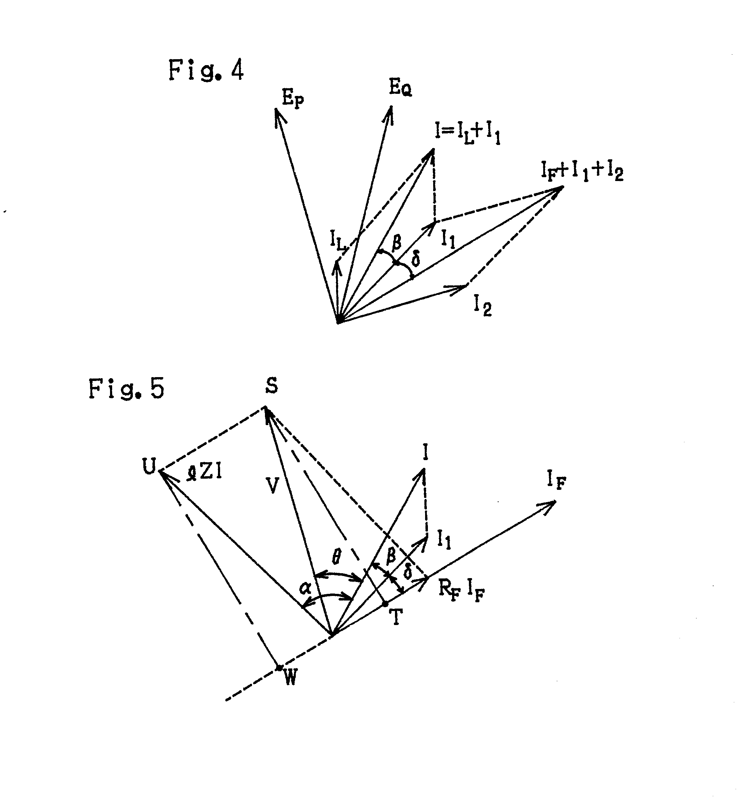

Now, as shown in Fig. 4, $E_Q$ is assumed to lag in phase
with respect to $E_P$, so that the load current $I_L$ is given in
the following equation (11):

$$I_L = \frac{E_P - E_Q}{Z_T} \qquad \cdots \cdots (11)$$

where $Z_T = Z_{gP} + L_Z + Zg_Q$.

Under this condition, when the fault occurs, the incre-
mental currents $I_1$ and $I_2$ during the occurrence of the fault
flow in the fault point, whereby a current 1 flowing in the
fault locator installation point is given in the following
equation (12):

$$I = I_L + I_1 \qquad \cdots \cdots (12)$$

In the equation (12), I and $I_L$ are currents flowing in
the fault locator installation point when the fault occurs

10

and the system is normal, thereby enabling the incremental current $I_1$ to be computed. In addition, in Fig. 4, reference $\beta$ designates a phase angle between I and $I_1$.

The fault current $I_F$ flowing in the fault point resistance $R_F$, which is the sum of the incremental current $I_1$ from the end P and that $I_2$ from the end Q, is given in the following equation (13):

$$I_F = I_1 + I_2 \qquad \cdots \cdots (13)$$

$I_2$ is not measured, but $I_F$ is obtained form the equation (18) to be described below. In Fig. 4, $\delta$ designates a phase angle between $I_1$ and $I_F$

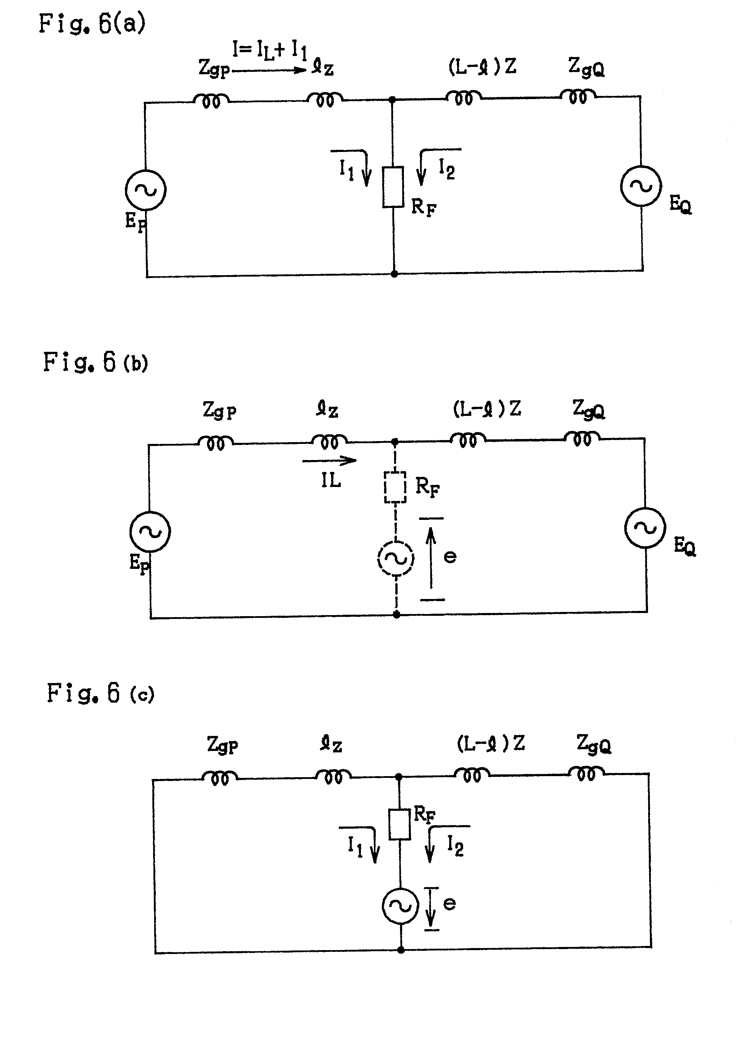

Fig. 5 shows the phase relation between the respective currents and voltages in the same way as Fig. 4, which is separate therefrom to avoid complication therewith.

The voltage V at the fault locator FL installation point when the fault occurs, which is the sum of impedance drop voltage to the fault point and fault point voltage, is given in the following equation (14):

$$V = \ell ZI + R_F I_F \qquad \cdots \cdots (14)$$

When $R_F I_F$ is assumed to be the reference, the sine component (the line segment ST) at the left side is equal to that (the segment UW) at the right side of equation (14), whereby the following equation (15) is obtained:

12

$$|V| \sin(\theta+\beta+\delta) = \ell \, |ZI| \sin(\alpha+\beta+\delta)$$

$$\cdots\cdots (15),$$

where  $\theta$ : a phase angle between voltage V and current I at the fault locator FL installation point, when the fault occurs and

 $\alpha$ : an impedance angle of complex impedance (Z = r+jx) per unit length of transmission line

$$\alpha = \tan^{-1}\left(\frac{x}{r}\right)$$

When an unknown value $\delta$ in the equation (15) is found, the distance $\ell$ to the fault point is obtained from the following equation:

$$\ell = \frac{|V| \sin(\theta+\beta+\delta)}{|ZI| \sin(\alpha+\beta+\delta)} \qquad \cdots\cdots (16).$$

Next, the value $\delta$ will be explained.

Fig. 6 shows equivalent circuits of the electric power system exploded into conditions before and after the occurrence of the fault by means of the super position, in which Fig. 6-(a) is an equivalent circuit diagram of the electric power system when the fault occurs and similar to Fig. 3.

Fig. 6-(b) shows that voltage e generated at the fault point is inserted in a phantom fashion in the circuit through the fault point resistance $R_F$ before the fault occurs, in which a zero current flows in $R_F$ and the load cur-

12

13

rent $I_L$ flows through a potential difference between $E_P$ and $E_Q$.

Fig. 6-(c) shows an incremental current during the occurrence of the fault, in which the supply voltage is applied reversely to aforesaid voltage e so that incremental currents $I_1$ and $I_2$ during the occurrence of the fault flow from the ends P and Q.

Therefore, it is clarified that, Fig. 6-(b) and Fig. 6-(c), when superposed with each other, become equivalent to Fig. 6-(a) from the theory of superposition, wherein the incremental currents $I_1$ and $I_2$ are given from Fig. 6-(c) in the following equations (17).

$$\left.\begin{aligned} I_1 &= \frac{Z_Q \cdot e}{Z_P Z_Q + R_F(Z_P + Z_Q)} \\ I_2 &= \frac{Z_P}{Z_Q} I_1 \end{aligned}\right\} \quad \cdots\cdots (17)$$

where $Z_P = Zg_P + \ell Z$

$Z_Q = (L-\ell)Z + Zg_Q$

Hence, the fault point current $I_F$ is given in the following equation (18):

$$I_F = I_1 + I_2 = \frac{Z_T}{Z_Q} I_1 \quad \cdots\cdots (18)$$

where $Z_T = Z_P + Z_Q = Zg_P + L_Z + Zg_Q$.

13

14

$$\frac{I_1}{I_F} = \left| \frac{Z_Q}{Z_T} \right| \angle \quad \underline{\phi Q - \phi T} \qquad ,$$

where $\phi Q$: an impedance angle of $Z_Q$, and

$\phi T$: an impedance angle of $Z_T$,

therefore,

$$\delta = \phi Q - \phi T \quad \cdots \cdots (19)$$

is obtained.

$\phi Q$ is given in the following equation (20) by the definition of $Z_Q$ in the equation (17):

$$\phi Q = \tan^{-1} \left\{ \frac{(L-\ell)x + Xg_Q}{(L-\ell)r + Rg_Q} \right\} \quad \cdots \cdots (20),$$

where r: resistance component per unit length of the transmission line,

x: reactance component per unit length of transmission line,

$Rg_Q$: resistance component of back impedance $Zg_Q$ at the end Q, and

$Xg_Q$: reactance component of back impedance $Zg_Q$ at the end Q.

Hence, from the equations (19) and (20),

$$\phi Q = \tan^{-1} \left\{ \frac{(L-\ell)x + Xg_Q}{(L-\ell)r + Rg_Q} \right\} = \delta + \phi T$$

is obtained, which is changed to obtain the following equation:

15

$$\tan(\delta + \phi T) = \frac{(L-\ell)x + Xg_Q}{(L-\ell)r + Rg_Q} \quad \cdots \cdots (21)$$

While,

$$\tan(\delta + \phi T) = \frac{\tan\delta + \tan\phi T}{1 - \tan\delta\tan\phi T} \quad \cdots \cdots (22)$$

is obtained, whereby $\tan\delta$ in the equations (21) and (22) is given in the following equation (23):

$$\tan\delta = \frac{A - \tan\phi T}{1 + A\tan\phi T} \quad \cdots \cdots (23).$$

where $A = \dfrac{(L-\ell)x + Zg_Q}{(L-\ell)r + Rg_Q}$ .

The function of $\delta$ obtained as above is substituted in the equation (15), at which time $\delta$ in the equation (15) is separated to obtain the following equation:

$$|V|\{\sin(\theta+\beta)\cos\delta+\cos(\theta+\beta)\sin\delta\}$$

$$=\ell|ZI|\{\sin(\alpha+\beta)\cos\delta+\cos(\alpha+\beta)\sin\delta\} .$$

Both sides of the above are divided by $\cos\delta$ and equation (23) is substituted into $\dfrac{\sin\delta}{\cos\delta} = \tan\delta$, whereby the following equation is obtained:

$$|V|\left\{\sin(\theta+\beta)+\cos(\theta+\beta)\frac{A - \tan\phi T}{1 + A\tan\phi T}\right\}$$

$$= \ell|ZI|\left\{\sin(\alpha+\beta)+\cos(\alpha+\beta)\frac{A - \tan\phi T}{1 + A\tan\phi T}\right\} .$$

16

Both sides of the above are multiplied by 1 + Atan$\phi$T and the left side is rearranged by A. Thus, the left side becomes.

$|V|$ [A $\{\sin(\theta+\beta)\tan\phi T\cos(\theta+\beta)\}$ + $\{\sin(\theta+\beta)-\cos(\theta+\beta)\tan\phi T\}$ ] .

The right side is similarly expanded to be

$\ell|ZI|$ [A $\{\sin(\alpha+\beta)\tan\phi T\cos(\alpha+\beta)\}$ + $\{\sin(\alpha+\beta)-\cos(\alpha+\beta)\tan\phi T\}$ ] .

Next, both sides are multiplied by $\cos\phi$T and rearranged of trigonometric functions, so that the following equation (24) is obtained:

$|V|(A\cos\mu+\sin\mu) = \ell|ZI|(A\cos\lambda+\sin\lambda)$

$\cdots\cdots(24)$

where $\mu = \theta+\beta-\phi T$, and

$\lambda = \alpha+\beta-\phi T.$

The A in the equation (23) is substituted into the equation (24) and thereafter both sides are multiplied by $(L-\ell)r+R_Q$ , whereby the left side becomes $|V|(B\cos\mu+D\sin\mu)-|V|(x\cos\mu+r\sin\mu)\ell$, and the right side becomes $|ZI|(B\cos\lambda+D\sin\lambda)\ell - |ZI|(x\cos\lambda+r\sin\lambda)\ell^2$. Hence, the following equation (25) is obtained:

$|ZI|(x\cos\lambda+r\sin\lambda)\ell^2- \{|ZI|(B\cos\lambda+D\sin\lambda)$

$+ |V|(x\cos\mu+r\sin\mu)\}\ell+ |V|(B\cos\mu+D\sin\mu)\} = 0$

$\cdots\cdots(25)$

16

17

where B = $Lx + Xg_Q$, and

D = $Lr + Rg_Q$.

Here, $x = |Z|\sin\alpha$ and $r = |Z|\cos\alpha$ from the definition of $\alpha$ in the equation (15) are substituted into the equation (25) to thereby obtain the following equation (26) is obtained:

$$|I|\sin(\alpha+\lambda)(|Z|\ell^2)$$

$$- \{|I|(B\cos\lambda+D\sin\lambda)+|V|\sin(\alpha+\mu)\}\,Z\ell$$

$$+ |V|(B\cos\mu+D\sin\mu)=0 \quad \cdots\cdots (26)$$

Accordingly, the distance $\ell$ to the fault point can be obtained from the following equation (27):

$$\ell = \frac{\sqrt{-b \pm b^2 - 4ac}}{2a|Z|} \quad \cdots\cdots (27)$$

where $a = |I|\sin(\alpha+\lambda)$,

$\quad\quad b = - \{|I|(B\cos\lambda+D\sin\lambda)+|V|\sin(\alpha+\mu)\}$,

$\quad\quad$ and

$\quad\quad c = |V|(B\cos\mu+D\sin\mu)$.

In addition, two values of distance to the fault point are obtained from the equation (27), one of which shows an accurate value, and the other is a value approximate to the distance to the power source for the end Q as shown below, thereby enabling the other value to be treated as an improper value. Herein, explanation will be given on one example of the nearest end fault ($R_F = 0$).

18

In this case, from V=0, a, b and c in the equation (27) are given in

$a = |I| \sin(\alpha+\lambda),$

$b = -|I| (B\cos\lambda+D\sin\lambda),$ and

$c = 0.$

Hence, the distance to the fault point is given in the following equation (28):

$$\ell = \frac{-b \pm b}{2a|Z|} = 0 \text{ or } \frac{-b}{a|Z|} \quad \cdots \cdots (28),$$

wherein the distance to the second point is obtained as follows:

$$\frac{-b}{a|Z|} = \frac{B\cos\lambda + D\sin\lambda}{|Z|\sin(\alpha+\lambda)} .$$

Then, the values given in the provisos of the equations (9) and (16) are substituted into B and D in the above, the following equation is obtained:

$$\frac{-b}{a|Z|} = \frac{(L|Z|\sin\alpha+Xg_Q)\cos\lambda+(L|Z|\cos\alpha+Rg_Q)\sin\lambda}{|Z|\sin(\alpha+\lambda)}$$

$$= L + \frac{|Zg_Q|\sin(\phi g_Q+\lambda)}{|Z|\sin(\alpha+\lambda)}$$

where $|ZgQ| = \sqrt{(Xg_Q)^2+(Rg_Q)^2}$ and

$$\phi g_Q = \tan^{-1}(\frac{Xg_Q}{Rg_Q}).$$

Since $\phi g_Q$ is an approximate value to $\alpha$, the distance to

18

the second point is the sum of the distance between the bus at the end P and that at the end Q and a converted value of the distance from the bus of the end Q to the power source $E_Q$, thereby being arranged as an improper value.

Incidentally, the aforesaid embodiment is described as to the single-phase power, but the present invention is applicable to the three-phase power.

When the fault location is carried out as fore-going, the fault point resistance is obtainable as follows:

In Fig. 3, from $V = I \ell Z + R_F I_F$,

$$R_F = \frac{V - I \ell Z}{I_F} \qquad \cdots \cdots (29)$$

is obtained. $I_F$ is eliminated through the equation (18), and $I_1$, through the equation (12), then the following equation is obtained:

$$R_F = \frac{Z_Q}{Z_T} \cdot \frac{V - I \ell Z}{I - 1_L} \qquad \cdots \cdots (30)$$

The fault locator carrying out the fault location as foregoing is provided with means for detecting current and voltage at the fault locator installation side sending end respectively, means for obtaining the phase angle from the detected current and voltage, and a distance computation unit for computing the equation (27) by use of the data obtained directly or indirectly from these means, that is, the

20

absolute value |I| of a current when the system is in fault at the locator installation point, the absolute value |V| of voltage similar to the above, the load current $I_L$, the incremental current $I_1$ $(=I-I_L)$, the phase angle $\beta$ of $I$ based on $I_1$ and that $\theta$ of $V$ based on $I$, and the data previously given as the constant, that is, the absolute value |Z| of impedance per unit length of the transmission line, the resistance component r and reactance component x of the complex impedance per unit length of the same, $\tan^{-1}\left(\dfrac{x}{r}\right)$ or $\alpha$, the angle $\phi T$ of the total impedance when the system is normal, and the resistance component D and reactance component B of the complex impedance from the locator installation point to the other sending end. The above means to obtain the current, voltage and phase angle, is well-known in itself and the distance computation unit can be composed by use of a microprocessor.

Also, the apparatus for measuring the fault point resistance must previously be given the data of $Zg_P$, $Zg_Q$ and L other than the data as to the aforesaid fault locator, so that the computation unit is so constructed as to enable computation of the equation (30).

As seen from the above construction, the voltage and current data of the other end is not required, whereby the

20

0239268

21

fault locator can be simplified to that extent and instantaneously locate the fault point and measure the fault point resistance without the need to transfer the data. Furthermore, the fault location or the fault point resistance measuring can be carried out without being affected by an error in fault location caused by the fault point resistance and the load current.

Next, explanation will be given on the measurement of impedance to the fault point at the three terminal system transmission line.

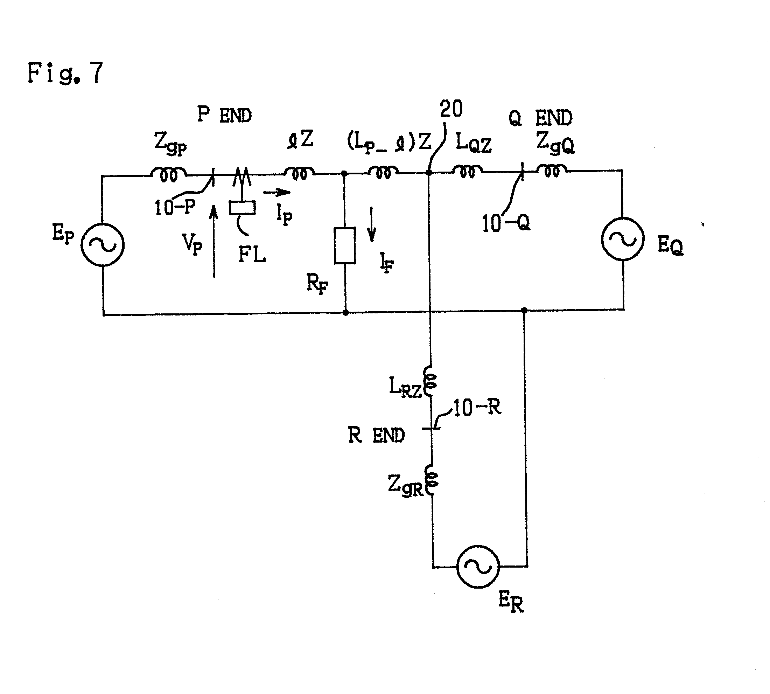

Fig. 7 is an equivalent circuit diagram of the three terminal system transmission line when the fault occurs in the same way as Fig. 2, in which the same components as those therein are designated by the same references.

In this drawing, voltage $V_P$ at the fault locator FL installation point when the fault occurs is the sum of impedance drop voltage to the fault point and the fault point voltage, which is given in the following equation (31):

$$V_P = \ell Z I_P + R_F I_F \quad \cdot \cdot \cdot \cdot \cdot \cdot (31)$$

where $I_F = I_1 + I_2 + I_3$.

In the equation (31), $V_P$ and $I_P$ are the known data measurable at the local end, while, $I_F$ is an unknown data.

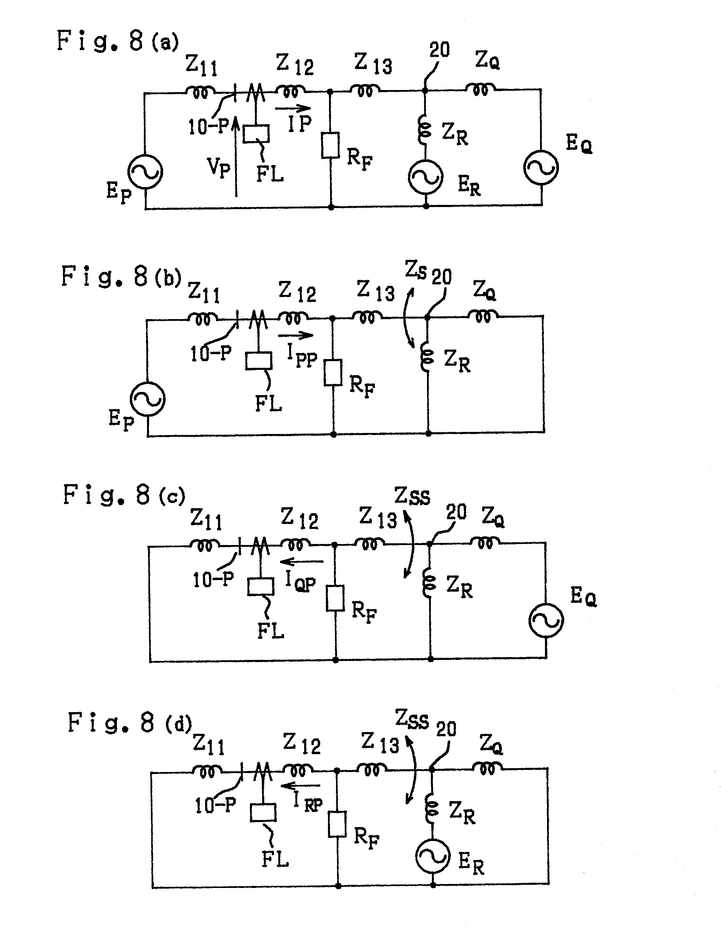

Figs. 8-(a) through -(d) are equivalent circuit diagrams showing that the current $I_P$ flowing when the fault oc-

22

curs is the sum of currents $I_{PP}$, $I_{QP}$ and $I_{RP}$ flowing from the supply voltages $E_P$, $E_Q$ and $E_R$ respectively, Figs. 8-(b), -(c) and -(d) showing the circuits with supply voltages $E_p$, $E_Q$ and $E_R$, Fig. 8-(a) showing the circuit superposing these circuits, that is, the circuit substantially the same as that in Fig. 7.

Assuming that, as shown the fault point is a little closer to the endP , from the directional properties of $I_{PP}$, $I_{QP}$ and $I_{RP}$, the following equation is obtained:

$$I_P = I_{PP} - I_{QP} - I_{RP} \cdots\cdots (32).$$

In addition, $I_{PP}$, $I_{QP}$ and $I_{RP}$ are obtained from Figs. 8-(b) through -(d), and lastly $I_P$ is obtained. In order to facilitate expansion of the equation, reference $Zg_P$ in Fig. 7 is replaced by $Z_{11}$ in Fig. 8, $\ell Z$ and $(L_P-\ell)Z$ in Fig. 7 by $Z_{12}$ and $Z_{13}$ in Fig. 8, and $L_Q Z + Zg_Q$ and $I_R Z + Zg_R$ by $Z_Q$ and $Z_R$ in Fig. 8.

Now, $I_{PP}$, $I_{QP}$ and $I_{RP}$ are computed as follows: (Computation of $I_{PP}$ )

In Fig. 8-(b), when $\dfrac{Z_Q \cdot Z_R}{Z_Q + Z_R}$ is represented by $Z_S$ , the following equation (33) is given:

$$I_{PP} = \cfrac{E_P}{\cfrac{(Z_S + Z_{13}) R_F}{Z_S + Z_{13} + R_F} + Z_{12} + Z_{11}}$$

23

$$= \frac{(Z_S + Z_{13} + R_F)E_P}{(Z_S + Z_{13})R_F + (Z_{12} + Z_{11})(Z_S + Z_{13} + R_F)}$$

$$= \frac{(Z_S + Z_{13} + R_F)E_P}{\Delta} \quad \cdots\cdots (33)$$

where $\Delta = (Z_S + Z_{13})(R_F + Z_{12} + Z_{11}) + (Z_{12} + Z_{11})R_F$

(Computation of $I_{QP}$)

In Fig. 8-(c), when $Z_{13} + \dfrac{R_F(Z_{12} + Z_{11})}{R_F + Z_{12} + Z_{11}}$ is represented

by $Z_{SS}$, the following equation (34) is obtained:

$$I_{QP} = \frac{E_Q}{\dfrac{Z_{SS}Z_R}{Z_{SS} + Z_R} + Z_Q} \cdot \frac{Z_R}{Z_{SS} + Z_R} \cdot \frac{R_F}{R_F + Z_{12} + Z_{11}}$$

$$= \frac{E_Q Z_R}{Z_{SS} + Z_S} \cdot \frac{1}{(Z_Q + Z_R)} \cdot \frac{R_F}{R_F + Z_{12} + Z_{11}}$$

$$= \frac{E_Q Z_R R_F}{\Delta} \cdot \frac{1}{Z_Q + Z_R} \quad \cdots\cdots (34)$$

(Computation of $I_{RP}$)

Considering similar to Fig. 8-(c), the following equation (35) is obtained from Fig. 8-(d).

$$I_{RP} = \frac{E_R Z_Q R_F}{\Delta} \cdot \frac{1}{Z_Q + E_R} \quad \cdots\cdots (35)$$

Next, $E_P$, $E_Q$ and $E_R$ in the equation (33) to (35) can be represented as follows:

(Computation of $E_P$)

24

From Fig. 8-(a), $E_P$ is given in the following equation (36):

$$E_P = V_P + Z_{11} I_P \cdots\cdots (36)$$

(Computation of $E_Q$)

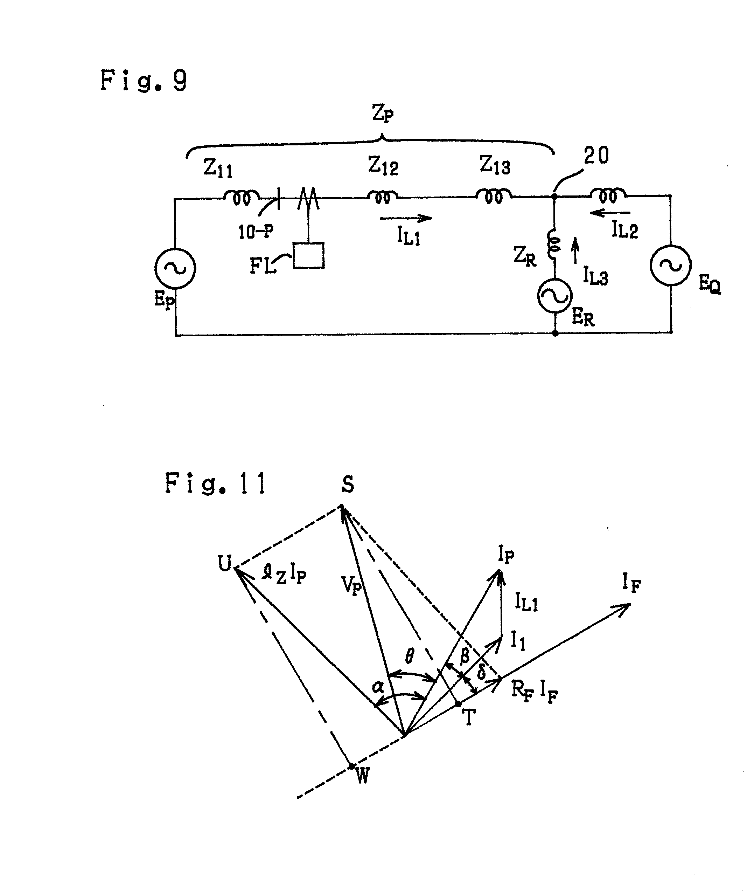

An equivalent circuit shown in Fig. 9 is given when the electric power system is normal.

When load currents flowing in the ends P, Q and R are represented by $I_{L1}$, $I_{L2}$ and $I_{L3}$ respectively, the following equation (37) should hold from the Kirchhoff's law:

$$I_{L1} + I_{L2} + I_{L3} = 0 \cdots\cdots (37)$$

Hence, $E_Q$ is given in the following equation (38):

$$E_Q = E_P - Z_P I_{L1} + Z_Q I_{L2}$$
$$= V_P + Z_{11} I_P - Z_P I_{L1} + Z_Q I_{L2} \cdots\cdots (38)$$

where $Z_P = Z_{11} + Z_{12} + Z_{13}$.

(Computation of $E_R$)

$E_R$, considering in the same way as the above, is given in the following equation (39):

$$E_R = E_P - Z_P I_{L1} + Z_R I_{L3}$$
$$= V_P + Z_{11} I_P - Z_P I_{L1} + Z_{12} I_{13} \cdots\cdots (39)$$

When the equation (33) to (39) are substituted into the equation (32), $I_P$ is given in the following equation (40):

$$I_P = I_{PP} - I_{QP} - I_{RP}$$
$$= \frac{1}{\Delta} \left\{ (Z_S + Z_{13} + R_F)(V_P + Z_{11} I_P) - \frac{Z_R R_F}{Z_Q + Z_R} \right.$$

25

$$\times (V_P + Z_{11} I_P - Z_P I_{L1} + Z_Q I_{L2}) - \frac{Z_Q R_F}{Z_Q + Z_R}$$

$$\times (V_P + Z_{11} I_P - Z_P I_{L1} + Z_R I_{L3})\} \quad \cdots \cdots (40)$$

When both sides of the equation (40) are multiplied by $(Z_Q + Z_R)\Delta$, the left side thereof is expressed by the following equation (41) and the right side by the following equation (42):

$$\text{Left side} = \{Z_Q Z_R + Z_{13}(Z_Q + Z_R)\}(R_F + Z_{12} + Z_{11}) I_P + (Z_Q + Z_R)$$
$$(Z_{12} + Z_{11}) R_F I_P$$

$$= \{Z_Q Z_R + (Z_Q + Z_R)(Z_{13} + Z_{12} + Z_{11})\} R_F I_P$$
$$+ \{Z_Q Z_R + Z_{13}(Z_Q + Z_R)\}(Z_{12} + Z_{11}) I_P$$

$$= (Z_P Z_Q + Z_Q Z_R + Z_R Z_P) R_F I_P$$
$$+ \{Z_Q Z_R + Z_{13}(Z_Q + Z_R)\}(Z_{12} + Z_{11}) I_P$$
$$\qquad \cdots \cdots (41)$$

(due to $Z_P = Z_{13} + Z_{12} + Z_{11}$ from the equation (38)).

$$\text{Right side} = (Z_Q + Z_R)(Z_S + Z_{13} + R_F)(V_P + Z_{11} I_P) - (Z_Q + Z_R) R_F$$
$$(V_P + Z_{11} I_P - Z_P I_{L1}) - Z_Q Z_R R_F (I_{L2} + I_{L3})$$

$$= \{Z_Q Z_R + (Z_Q + Z_R)(Z_{13} + R_F) - (Z_Q + Z_R) R_F\}(V_P + Z_{11} I_P)$$
$$+ (Z_Q + Z_R) R_F Z_P I_{L1} + Z_Q Z_R R_F I_{L1}$$

(due to $I_{L2} + I_{L3} = -I_{L1}$ from the equation (37))

$$= \{Z_Q Z_R + Z_{13}(Z_Q + Z_R)\}(V_P + Z_{11} I_P) +$$
$$(Z_P Z_Q + Z_Q Z_R + Z_R Z_P) R_F I_{L1} \quad \cdots \cdots (42)$$

Accordingly, from the equations (41) and (42), the equations (40) becomes the following equation (43):

$$(Z_P Z_Q + Z_Q Z_R + Z_R Z_P) R_F (I_P - I_{L1})$$
$$= \{Z_Q Z_R + Z_{13}(Z_Q + Z_R)\}(V_P - Z_{12} I_P) \cdot \cdot \cdot \cdot \cdot \cdot (43)$$

The equation (43), as discussed below, can be represented by the following equation (44).

$$R_F I_F = V_P - Z_{12} I_P \cdot \cdot \cdot \cdot \cdot \cdot (44)$$

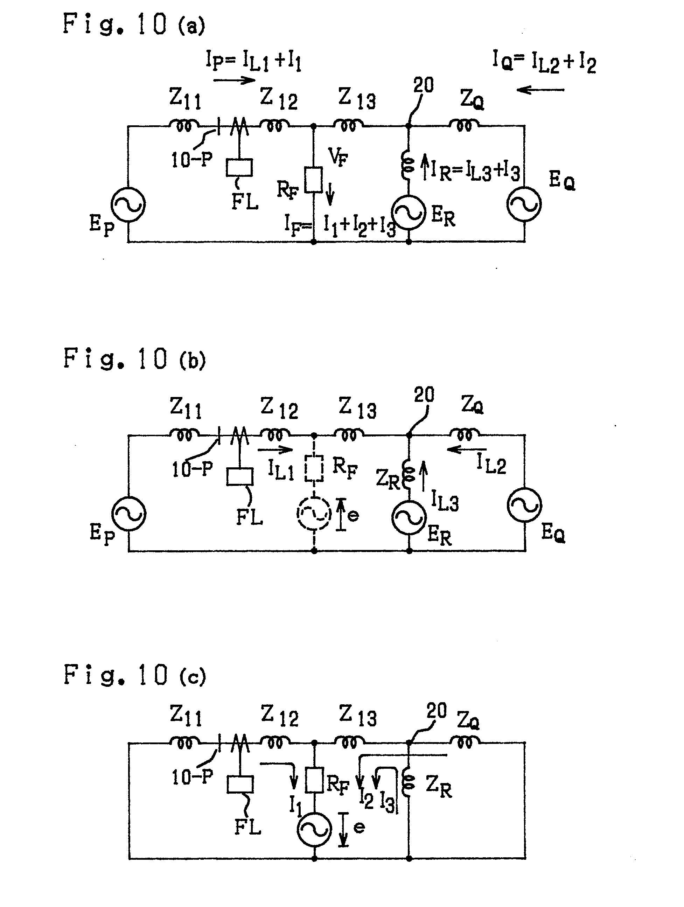

Fig. 10 is an equivalent circuit diagram of the electric power system exploded by the theory of superposition into the state before the fault occurs and that when the fault occurs, in which Fig. 10-(a) corresponds to Fig. 7 and Fig. 8-(a).

Fig. 10-(b) shows that voltage e generated at the fault point before the fault occurs is assumed to be imaginarily inserted into the circuit through fault point resistance $R_F$, which shows that a current flowing in $R_F$ is zero and the load currents $I_{L1}$, $I_{L2}$ and $I_{L3}$ flow from supply voltages $E_P$, $E_Q$ and $E_R$ respectively.

Fig. 10-(c) shows incremental currents during the occurrence of the fault, in which the supply voltage is applied in the reverse direction to the voltage e and the incremental currents $I_1$, $I_2$ and $I_3$, when the fault occurs, are flowing.

Accordingly, it is seen that Fig. 10-(b) and Fig. 10-(c), when superposed with each other, become equivalent to Fig. 10-(a).

27

The incremental currents $I_1$, $I_2$ and $I_3$ are given from Fig. 10-(c) in the following equations (45) to (47):

$$I_1 = \frac{e}{Z_W} \cdot \frac{Z_U}{Z_U + Z_{12} + Z_{11}} = \frac{eZ_U}{R_F(Z_U + Z_{12} + Z_{11}) + Z_U(Z_{12} + Z_{11})},$$

where $\quad Z_U = Z_{13} + \dfrac{Z_Q Z_R}{Z_Q + Z_R} \quad$ and

$$Z_W = R_F + \frac{Z_U(Z_{12} + Z_{11})}{Z_U + Z_{12} + Z_{11}}.$$

The $I_1$ in the above equation is simplified as

$$I_1 = \frac{eZ_U}{Z_Y} \qquad \cdots \cdots (45)$$

where $\quad Z_Y = R_F(Z_U + Z_{12} + Z_{11}) + Z_U(Z_{12} + Z_{11}).$

$$I_2 = \frac{e}{Z_W} \cdot \frac{Z_{12} + Z_{11}}{Z_U + Z_{12} + Z_{11}} \cdot \frac{Z_R}{Z_Q + Z_R} = \frac{e(Z_{12} + Z_{11})Z_R}{Z_Y(Z_Q + Z_R)} \cdots \cdots (46)$$

$$I_3 = \frac{e}{Z_W} \cdot \frac{Z_{12} + Z_{11}}{Z_U + Z_{12} + Z_{11}} \cdot \frac{Z_Q}{Z_Q + Z_R} = \frac{e(Z_{12} + Z_{11})Z_Q}{Z_Y(Z_Q + Z_R)} \cdots \cdots (47)$$

Hence, a current $I_F$ flowing in the fault point is given in the following equation (48):

$$I_F = I_1 + I_2 + I_3 = \frac{I_1}{Z_U}(Z_U + Z_{12} + Z_{11})$$

$$= \frac{I_1}{Z_Q Z_R + Z_{13}(Z_Q + Z_R)} \cdot \{Z_Q Z_R + (Z_{13} + Z_{12} + Z_{11})(Z_Q + Z_R)\}$$

$$= \frac{Z_P Z_Q + Z_Q Z_R + Z_R Z_P}{Z_Q Z_R + Z_{13}(Z_Q + Z_R)} \cdot (I_P - I_{L1}) \cdots \cdots (48)$$

28

When the equation (48) is substituted into that (43), it is formed that the equation (44) should hold.

On the other hand, from $Z_S = \dfrac{Z_Q Z_R}{Z_Q + Z_R}$ and $Z_{12} = (L_P - \ell)Z$, the equation (48) also is expressed by the following equation (49):

$$I_F = \frac{Z_S + Z_P}{Z_S + (L_P - \ell)} \, I_1 \quad \cdots \cdots (49)$$

When $Z_{12}$ in the equation (44) is replaced by $\ell Z$ shown in Fig. 7, the following equation is obtained:

$$R_F I_F = V_P - \ell Z I_P \quad \cdots \cdots (50)$$

The equation (50) itself can directly be introduced from Fig. 7 and it will be apparent that the respective components in the equation (50), in comparison with the aforesaid equations, relate to what in the system constitution.

Fig. 11 shows the respective components in the equation (50), in which the sum of voltage drop $R_F I_F$ occurring at the fault point resistance $F_F$ and that $\ell Z I_P$ occurring at the impedance $\ell Z$ to the fault point, is represented by voltage $V_P$ at the fault locator FL installation point. In the drawing, reference $I_P$ designates a current flowing in the fault locator FL installation point when the fault occurs, $\theta$ designates a phase angle between $V_P$ and $I_P$, $\alpha$ designates an impedance angle of impedance $(Z = r + jx)$ per unit length of the

29

transmission line and a value obtained by $\tan \alpha = \tan^{-1}(\frac{X}{Y})$, $I_1$

designates an incremental current flowing from the sending end P into the fault point when the fault occurs and of a value obtained from $I_P - I_{L1}$, where $I_{L1}$ is a load current flowing in the FL installation point and in the state where

no fault occurs, $\beta$ designates a phase angle between $I_P$ and

$I_1$, $I_F$ designates a current flowing in the fault point, and

$\delta$ designates a phase angle between $I_1$ and $I_F$.

From the above, the sine component of $V_P$ component hav-

ing the $R_F I_F$ component as a reference value is equal to that

of the $\ell Z I_P$ component, so that the following equation (51) should hold:

$$|V_P| \sin(\theta + \beta + \delta) = \ell |ZI_P| \sin(\alpha + \beta + \delta) \quad \cdots \cdots (51)$$

In the above equation, values other than $\delta$ are already

known, so that $\delta$ will be discussed as follows:

From the equation (49), as to $\delta$, it is given as a phase

angle of $I_1$ with respect to $I_F$ in the following equation

(52):

$$\frac{I_1}{I_F} = \frac{Z_S + (I_P - \ell)Z}{Z_S + Z_P} = \frac{|Z_S + (I_P - \ell)Z|}{|Z_S + Z_P|} \angle \phi Q - \phi T$$

$$\cdots \cdots \cdots (52)$$

where $\phi Q$ is an impedance angle of $Z_S + (I_P - \ell)Z$, and

$\phi T$ is an impedance angle of $Z_S + Z_P$.

30

From $\phi Q - \phi T$ is $\delta$, the following equation (53) should hold:

$$\phi Q = \delta + \phi T. \quad \cdots \cdots (53)$$

Meanwhile, $\phi Q$ is given in the following equation (54):

$$\phi Q = \tan^{-1} \left\{ \frac{X_S + (L_P - \ell) x}{R_S + (L_P - \ell) r} \right\} \quad \cdots \cdots (54)$$

where $X_S$: reactance component of $Z_S$,

$\quad$ $R_S$: resistance component of $Z_S$,

$\quad$ x : reactance component per unit length of the

$\quad\quad$ transmission line, and,

$\quad$ r : resistance component per unit length of the same.

From the equation (53) and (54), the following equation (55) should hold:

$$\tan(\delta + \phi T) = \frac{X_S + (L_P - \ell) x}{R_S + (L_P - \ell) r} \quad \cdots \cdots (55)$$

On the other hand, $\tan(\delta + \phi T)$ is represented by

$$\tan(\delta + \phi T) = \frac{\tan \delta + \tan \phi T}{1 - \tan \delta \tan \phi T} \quad ,$$

then, the above is substituted into the equation (55), $\tan \delta$ is represented by the following equation (56):

$$\tan \delta = \frac{A - \tan \phi T}{1 + A \tan \phi T},$$

$$\text{where } A = \frac{X_S + (L_P - \ell) x}{R_S + (L_P - \ell) r} \quad .$$

30

31

The function of $\delta$ thus obtained is substituted into the equation (51), at which time the equation (51) is transferred as to $\delta$ as follows:

$$|V_P| \{\sin(\theta+\beta)\cos\delta+\cos(\theta+\beta)\sin\delta\}$$

$$= \ell|ZI_P| \{\sin(\alpha+\beta)\cos\delta+\cos(\alpha+\beta)\sin\delta\}.$$

Both sides of the above are divided by $\cos \delta$ and the equation (56) is substituted into a term of $\dfrac{\sin\delta}{\cos\delta}= \tan\delta$, the following equation is obtained:

$$|V_P| \{\sin(\theta+\beta)+\cos(\theta+\beta)\frac{A-\tan\phi T}{1+A\tan\phi T}\}$$

$$= e|ZI_P| \{\sin(\alpha+\beta)+\cos(\alpha+\beta) \frac{A-\tan\phi T}{1+A\tan\phi T}.$$

The above equation is multiplied by $1+A\tan\phi T$ and the left side is rearranged as to A and given in

$$|V_P| [A\{\sin(\theta+\beta)\tan\phi T+\cos(\theta+\beta)\} + \{\sin(\theta+\beta)-\cos(\theta+\beta) \tan\phi T\} ].$$

The right side is similarly expanded, so that it is seen that $|V_P|$ need only be replaced by $\ell|ZI_P|$ and $\theta T$ by $\delta$.

Next, both sides are multiplied by $\cos\theta T$ and rearranged by trigonometric function terms, whereby the following equation (57) is obtained:

$$|V_P| (A\cos\mu+\sin\mu)=\ell|ZI_P| (A\cos\lambda+\sin\lambda) \cdots\cdots (57)$$

where $\mu = \theta+\beta-\phi T$ and

31

32

$$\lambda = \alpha - \beta + \phi T$$

Substitute A at the equation (56) into the equation (57) and thereafter both sides thereof are multiplied by $R_S + (L_P - \ell)r$, then the left side is represented by $|V_P|(B\cos\mu + D\sin\mu) - |V_P|(x\cos\mu + r\sin\mu)\ell$ and the right side by $|ZI_P|(B\cos\lambda + D\sin\lambda)\ell - |ZI_P|(X\cos\lambda + r\sin\lambda)\ell^2$. Hence, the following equation (58) is obtained:

$$|ZI_P|(x\cos\lambda + r\sin\lambda)\ell^2 - \{|ZI_P|(B\cos\lambda + D\sin\lambda) +$$
$$|V_P|(X\cos\mu + r\sin\mu)\ell\} + |V_P|(B\cos\mu + D\sin\mu) = 0$$

$$\cdots \cdots (58)$$

where $B = X_S + L_P x$ and

$$D = R_S + L_P r.$$

From $Z = r + jx$ and $\alpha = \tan^{-1}(\dfrac{x}{r})$, when $x = |Z|\sin\alpha$ and $r = |Z|\cos\alpha$ are substituted into the equation (58), the following equation (59) is obtained:

$$|I_P|\sin(\alpha + \lambda)(|Z|\ell)^2 - \{|I_P|(B\cos\lambda + D\sin\lambda) +$$
$$|V_P|\sin(\alpha + \mu)\}|Z|\ell + |V_P|(B\cos\mu + D\sin\mu) = 0$$

$$\cdots \cdots (59)$$

Accordingly, distance $\ell$ to the fault point can be obtained by the following equation (60):

$$\ell = \frac{-b \pm \sqrt{b^2 - 4ac}}{2a|Z|} \qquad \cdots \cdots (60)$$

33

where  $a = |I_P| \sin(\alpha+\lambda)$

$b = -\{|I_P|(B\cos\alpha+D\sin\lambda)+|V_P|\sin(\alpha+\mu)\}$

$c = |V_P|(B\cos\mu+D\sin\mu).$

In addition, from the equation (60), two solutions of impedance to the fault point are obtained, one of which shows an accurate value and the other can be disposed as improper value as described below.

Explanation will be given on, for example, the fault at a near end ($R_F=0$).  Since $V_P=0$, a, b and c are given in:

$a = |I_P|\sin(\alpha+r),$

$b = -|I_P|(B\cos\lambda+D\sin\lambda),$ and

$c = 0.$

Hence, impedance to the fault point is given in the following equation (61):

$$\ell = \frac{-b\pm b}{2a|Z|} = 0 \ or \ \frac{-b}{a|Z|} \quad \cdots\cdots (61)$$

the other solution is obtained as:

$$\frac{-b}{a|Z|} = \frac{B\cos\lambda + D\sin\lambda}{|Z|\sin(\alpha+\lambda)}$$

When the definition values in the equation (58) are substituted into B and D, the following equation is obtained:

$$\frac{-b}{a|Z|} = \frac{(X_S+L_P|Z|\sin\alpha)\cos\lambda+(R_S+L_P|Z|\cos\alpha)\sin\lambda}{|Z|\sin(\alpha+\lambda)}$$

33

34

From the definition in the equation (54), $Z_S = R_S + jX_S$ is obtained, so that when $\tan^{-1}(\dfrac{X_S}{R_S})$ is replaced by $\phi s$, $X_S = Z_S \sin\phi s$ and $R_S = Z_S \cos\phi s$ are obtained. Hence, the following equation is obtained:

$$\dfrac{-b}{a|Z|} = \dfrac{Z_S(\sin\phi s \cos\lambda + \cos\phi s \sin\lambda) + L_P Z(\sin\alpha\cos\lambda + \cos\alpha\sin\lambda)}{|Z|\sin(\alpha+\lambda)}$$

$$= L_P + \dfrac{|Z_S|\sin(\phi s+\lambda)}{|Z|\sin(\alpha+\lambda)} .$$

Herein, since $\phi s$ is an approximate value to $\alpha$, the second impedance solution is the sum of impedance $L_P Z$ from the bus at the end P to the junction and a parallel impedance value from the junction to the power source at the other end, the sum being a value when the fault occurs at the farthest end, thereby being disposed as an improper value.

In addition, the aforesaid embodiment is described as to the single phase power, but applicable to the three pulse power.

Furthermore, the fault point resistance is obtainable as follows:

From the equation (50),

$$R_F = \dfrac{V_P - ZI_P}{I_F}$$

is obtained, wherein $lZ$ is replaced by the aforesaid al-

35

ready-obtained value and the equation (52) is substituted into $I_F$, then the following equation is obtained:

$$R_F = \frac{Z_S + (L_P - \ell)Z}{Z_S + Z_P} \cdot \frac{V_P - \ell Z I_P}{I_1} \, ,$$

wherein $I_1$ is obtained from $I_1 = I_P - I_{L1}$, whereby $R_F$ is obtained as follows:

$$R_F = \frac{Z_S + (L_P - \ell)Z}{Z_S + Z_P} \cdot \frac{V_P - \ell Z I_P}{I_P - I_{L1}} \quad \cdots \cdots (62)$$

Thus, $R_F$ is obtainable from the equation (63).

As seen from the above, the apparatus for measuring distance $\ell$ can be constituted as, for example, part of fault locator and provided with the following means: means for detecting currents and voltages at the apparatus installation end side, means for obtaining the phase angle form the detected current and voltage, and the distance computation unit for computing the equation (60) by use of the data obtained directly or indirectly by these means, that is, the absolute value $|I_P|$ of the current flowing when the fault occurs at the system including the apparatus installation point, the absolute value of voltage, load current $I_{L1}$, incremental current $I_1 (= I_P - I_{L1})$, and phase angle $\beta$ of $I_P$ based on $I_1$ and that $\theta$ of $V_P$ based on $I_P$, and the data previously given as the constant, that is, the absolute value $|Z|$ of impedance per unit length of the transmission

35

36

line, the resistance component r and reactance component x
of the complex impedance per unit length of the transmission
line, $\tan^{-1}\left(\dfrac{x}{r}\right)$: $\alpha$, impedance $Z_S$ and $Z_P$ of the system,
and the resistance component D and reactance component B of
the complex impedance from the apparatus installation point
to the other end. The abovementioned means for obtaining
the current, voltage and phase angle are well-known in themselves and the distance computation unit can be constituted
of a microprocessor.

The apparatus for measuring the fault point resistance
need only be provided with the voltage, current and phase
angle detecting means similar to the above, and the computing unit enabling computation of the equation (62).

As seen from the above-mentioned construction, there is
no need or using the voltage and current data at the other
end, thereby simplifying the apparatus to that extent. Also, no data transmission is required to enable the distance $\ell$
and resistance $R_F$ to be instantaneously measured. Furthermore, the impedance or resistance can be measured with high
accuracy without being affected by the fault point resistance and load current.

As this invention may be embodied in several forms
without departing from the spirit of essential characteris-

37

tics thereof, the present embodiment is therefore illustrative and not restrictive, since the scope of the invention is defined by the appended claims rather than by the description preceding them, and all changes that fall within the meets and bounds of the claims, or equivalence of such meets and bounds thereof are therefore intended to be embraced by the claims.

38

What is claimed is:

1.  A fault point locating method for a two-terminal system transmission line having both end power sources, characterized in that the distance $\ell$ from one end to the fault point is computed by the following equation:

$$\ell = \frac{-b \pm \sqrt{b^2 - 4ac}}{2a|Z|}$$

where    $a = |I| \sin(\alpha + \lambda)$,

$b = -\{|I|(B \cos\lambda + D \sin\lambda) + |V| \sin(\alpha + \mu)\}$,

$c = |V|(B \cos\mu + D \sin\mu)$

$|Z|$: the absolute value of impedance Z per unit length of the transmission line and represented by $\sqrt{r^2 + x^2}$,

r: a resistance component per unit length of the transmission line,

x: a reactance component per unit length of the transmission line,

$\alpha$: a line angle of the transmission line and a value represented by $\alpha = \tan^{-1}(\dfrac{x}{r})$,

$|I|$: the absolute value of a current I at said one end side when a fault occurs,

$|V|$: the absolute value of voltage V at said one end side when the fault occurs,

$\lambda$: a value represented by $\alpha + \beta - \phi T$,

$\mu$: a value represented by $\theta + \beta - \phi T$,

$\beta$: a phase angle of I based on $I_1$,

$I_1$: an incremental current generated when the fault occurs and represented by $I - I_L$,

$I_L$: a load current,

$\phi T$: an angle of total impedance when the system is normal,

$\theta$: a phase angle of voltage V based on I,

B: a reactance component from said one end to the other end, and

D: a resistance component from said one end to the other end.

2.  A fault locator for locating a fault in a two-terminal system transmission line having both end power sources, comprising

means for detecting a current and voltage at one end,

means for obtaining a phase angle from detected current and voltage, and

a computing unit for carrying out the following equation by use of the data obtained directly or indirectly by both said means and the preset data, thereby computing

40

the distance $\ell$ from said one end to the fault point:

$$\ell = \frac{-b \pm\sqrt{b^2 - 4ac}}{2a|Z|}$$

where  a = $|I|$ sin $(\alpha + \lambda)$,

b = $-\{|I|(B \cos\lambda + D \sin\lambda)+|V| \sin(\alpha+\mu)\}$,

c = $|V|(B \cos\mu + D \sin\mu)$

$|Z|$: the absolute value of impedance Z per unit length of the transmission line and represented by
$\sqrt{r^2 + x^2}$ ,

r: a resistance component per unit length of the transmission line,

x: a reactance component per unit length of the

transmission line,

$\alpha$: a line angle of the transmission line and a value

represented by $\alpha = \tan^{-1}(\frac{x}{r})$,

$|I|$: the absolute value of a current I at said one end side when a fault occurs,

$|V|$: the absolute value of voltage V at said one end side when the fault occurs,

$\lambda$: a value represented by $\alpha+\beta-\phi T$,

$\mu$: a value represented by $\theta+\beta-\phi T$,

$\beta$: a phase angle of I based on $I_1$,

$I_1$: an incremental current generated when the fault

4l

occurs and represented by $I - I_L$,

$I_L$: a load current,

$\phi T$: an angle of total impedance when the system is normal,

$\theta$: a phase angle of voltage V based on l,

B: a reactance component from said one end to the other end, and

D: a resistance component from said one end to the other end.

3. A method for measuring fault point resistance at a two-terminal system transmission line having both end power sources, characterized in that the fault point resistance $R_F$ is computed by the following equation:

$$R_F = \frac{Z_Q}{Z_T} \cdot \frac{V - I\ell Z}{I - I_L}$$

where $\ell = \dfrac{-b \pm\sqrt{b^2 - 4ac}}{2a|Z|}$

$a = |I| \sin(\alpha + \lambda)$,

$b = -\{|I|(B\cos\lambda + D\sin\lambda) + |V|\sin(\alpha+\mu)\}$,

$c = |V|(B\cos\mu + D\sin\mu)$

$Z, |Z|$: Z is impedance per unit length of the transmission line and $|Z|$ is the absolute

41

42

value of Z and represented by $\sqrt{r^2 + x^2}$,

r: a resistance component per unit length of the
transmission line,

x: a reactance component per unit length of the
transmission line,

$\alpha$: a line angle of the transmission line and a value
represented by $\alpha = \tan^{-1}(\dfrac{x}{r})$,

I, |I|: a current flowing in one end when a fault
occurs and the absolute value thereof,

V, |V|: a voltage at said one end when the fault
occurs and the absolute value thereof,

$\lambda$: a value represented by $\alpha + \beta - \phi T$,

$\mu$: a value represented by $\theta + \beta - \phi T$,

$\beta$: a phase angle of I based on $I_1$,

$I_1$: an incremental current generated when the fault
occurs and represented by $I - I_L$,

$I_L$: a load current,

$Z_T$: total impedance when the system is normal,

$Z_Q$: the sum of impedance from the fault point to the
other end and back impedance thereof,

$\phi T$: an angle of total impedance when the system is
normal,

$\theta$: a phase angle of voltage V based on l,

B: a reactance component from said one end to the

43

other end, and

D: a resistance component from said one end to the other end.

4. An apparatus for measuring fault point resistance $R_F$ at a two-terminal system transmission line having both end power sources, comprising,

means for detecting a current and voltage at one end,

means for obtaining a phase angle from detected current and voltage, and

a computing unit for computing the following equation by use of the data obtained directly or indirectly by both said means and the preset data:

$$R_F = \frac{Z_Q}{Z_T} \cdot \frac{V - I\ell Z}{I - I_L}$$

where $\ell = \dfrac{-b \pm \sqrt{b^2 - 4ac}}{2a|Z|}$

$a = |I| \sin(\alpha + \lambda)$,

$b = -\{|I|(B\cos\lambda + D\sin\lambda) + |V|\sin(\alpha+\mu)\}$,

$c = |V|(B\cos\mu + D\sin\mu)$

$Z$, $|Z|$: $Z$ is impedance per unit length of the transmission line and $|Z|$ is the absolute value of $Z$ and represented by $\sqrt{r^2 + x^2}$,

44

r: a resistance component per unit length of the transmission line,

x: a reactance component per unit length of the transmission line,

$\alpha$: a line angle of the transmission line and a value represented by $\alpha = \tan^{-1}(\frac{x}{r})$,

I, |I|: a current flowing in one end when a fault occurs and the absolute value thereof,

V, |V|: a voltage at said one end when the fault occurs and the absolute value thereof,

$\lambda$: a value represented by $\alpha + \beta - \phi T$,

$\mu$: a value represented by $\theta + \beta - \phi T$,

$\beta$: a phase angle of I based on $l_1$,

$I_1$: an incremental current generated when the fault occurs and represented by $I - I_L$,

$I_L$: a load current,

$Z_T$: total impedance when the system is normal,

$Z_Q$: the sum of impedance from the fault point to the other end and back impedance thereof,

$\phi T$: an angle of total impedance when the system is normal,

$\theta$: a phase angle of voltage V based on I,

B: a reactance component from said one end to the other end, and

45

D: a resistance component from said one end to the other end.

5.   A method for measuring impedance from one end to a fault point at a three-terminal system transmission line, characterized in that the distance $\ell$ from one end to the fault point is computed by the following equation:

$$\ell = \frac{-b \pm \sqrt{b^2 - 4ac}}{2a|Z|}$$

where   $a = |I_P| \sin(\alpha + \lambda)$,

$b = -\{|I_P|(B\cos\lambda + D\sin\lambda) + |V_P|\sin(\alpha + \mu)\}$,

$c = |V_P|(B\cos\mu + D\sin\mu)$

$|Z|$: the absolute value of impedance Z per unit length of the transmission line and represented by $\sqrt{r^2 + x^2}$ ,

r: a resistance component per unit length of the transmission line,

x: a reactance component per unit length of the transmission line,

$\alpha$: a line angle of the transmission line and a value represented by $\alpha = \tan^{-1}(\frac{x}{r})$,

$|I_P|$: the absolute value of a current $I_P$ flowing in said one end when a fault occurs,

$|V_P|$: the absolute value of voltage $V_P$ at said one

46

end side when the fault occurs,

$\lambda$: a value represented by $\alpha + \beta - \phi T$,

$\mu$: a value represented by $\theta + \beta - \phi T$,

$\beta$: a phase angle of $I_P$ based on $I_1$ ,

$I$ : an incremental current generated when a fault occurs and represented by $I_P - I_{L1}$ ,

$I_{L1}$: a load current,

$\phi T$: an impedance angle of $Z_S + Z_P$ ,

$Z_S$: impedance when the other end is viewed from the junction at the system,

$Z_P$: the sum of impedance from said one end to the junction at the system and back impedance,

$\theta$: a phase angle of voltage $V_P$ based on $I_P$,

B: a reactance component from said one end to the other end, and

D: a resistance component from said one end to the other end.


6.   An apparatus for measuring impedance from one end to a fault point at a three-terminal system transmission line, comprising

means for detecting a current and voltage at one end,

means for obtaining a phase angle from detected current

and voltage, and

47

a computation unit for computing the following equation by use of the data obtained directly or indirectly by both means and the preset data:

$$\ell = \frac{-b \pm \sqrt{b^2 - 4ac}}{2a|Z|}$$

where  $a = |I_P| \sin(\alpha + \lambda)$,

$b = - \{|I_P|(B\cos\lambda + D\sin\lambda)+|V_P|\sin(\alpha+\mu)\}$,

$c = |V_P|(B\cos\mu + D\sin\mu)$

$|Z|$: the absolute value of impedance Z per unit length of the transmission line and represented by $\sqrt{r^2 + x^2}$ ,

r: a resistance component per unit length of the transmission line,

x: a reactance component per unit length of the transmission line,

$\alpha$: a line angle of the transmission line and a value represented by $\alpha = \tan^{-1}(\frac{x}{r})$,

$|I_P|$: the absolute value of a current $I_P$ flowing in said one end when a fault occurs,

$|V_P|$: the absolute value of voltage $V_P$ at said one end side when the fault occurs,

$\lambda$: a value represented by $\alpha+\beta-\phi T$,

$\mu$: a value represented by $\theta+\beta-\phi T$,

$\beta$: a phase angle of $I_P$ based on $I_1$ ,

47

$I_1$: an incremental current generated when the fault occurs and represented by $I_P - I_{L1}$,

$I_{L1}$: a load current,

$\phi T$: an impedance angle of $Z_S + Z_P$,

$Z_S$: impedance when the other end is viewed from the junction at the system,

$Z_P$: the sum of impedance from said one end to the junction at the system and back impedance,

$\theta$: a phase angle of voltage $V_P$ based on $I_P$,

B: a reactance component from said one end to the other end, and

D: a resistance component from said one end to the other end.

7.   A method for measuring fault point resistance at a three-terminal system transmission line, characterized in that fault point resistance R  is computed by a following equation:

$$R_F = \frac{Z_S + (I_P - \ell)Z}{Z_S + Z_P} \cdot \frac{V_P - \ell Z I_P}{I_P - I_{L1}}$$

where   $$\ell = \frac{-b \pm \sqrt{b^2 - 4ac}}{2a|Z|}$$

where   $a = |I_P| \sin(\alpha + \lambda)$,

$b = -\{|I_P|(B\cos\lambda + D\sin\lambda) + |V_P|\sin(\alpha+\mu)\}$,

49.

$c = |V_P| (B \cos\mu + D \sin\mu)$

$Z, |Z|$: Z is impedance per unit length of the transmission line, and $|Z|$ is the absolute value of Z per unit length of the transmission line and represented by $\sqrt{r^2 + x^2}$,

r: a resistance component per unit length of the transmission line,

x: a reactance component per unit length of the transmission line,

$\alpha$: a line angle of the transmission line and a value represented by $\alpha = \tan^{-1}(\dfrac{x}{r})$,

$I_P, |I_P|$: a current flowing in said one end when a fault occurs and the absolute value thereof,

$V_P, |V_P|$: voltage at said one end when the fault occurs and the absolute value thereof,

$\lambda$: a value represented by $\alpha + \beta - \phi T$,

$\mu$: a value represented by $\theta + \beta - \phi T$,

$\beta$: a phase angle of $I_P$ based on $I_1$,

$I_1$: an incremental current generated when the fault occurs and represented by $I_P - I_{L1}$,

$I_{L1}$: a load current,

$\phi T$: an impedance angle of $Z_S + Z_P$,

$Z_S$: impedance when the other end is viewed from the junction at the system,

50

$Z_p$ : the sum of impedance from said one end to the
junction at the system and back impedance,

$\theta$ : a phase angle of voltage $V_p$ based on $I_p$,

B: a reactance component from said one end to the
other end, and

D: a resistance component from said one end to the
other end.


8.      An apparatus for measuring a fault point resistance R
at a three-terminal system transmission line, comprising

means for detecting a current and voltage at one end,

means for obtaining a phase angle from detected current
and voltage, and

a computing unit for computing the following equation
by use of the data obtained directly or indirectly by said
both means and the preset data:

$$R_F = \frac{Z_S + (L_p - \ell)Z}{Z_S + Z_P} \cdot \frac{V_P - \ell Z I_p}{I_P - I_1}$$

where      $\ell = \dfrac{-b \pm \sqrt{b^2 - 4ac}}{2a|Z|}$

where   $a = |I_p| \sin(\alpha + \lambda)$,

$b = -\{|I_p|(B\cos\lambda + D\sin\lambda) + |V_p|\sin(\alpha+\mu)\}$,

$c = |V_p|(B\cos\mu + D\sin\mu)$

$Z, |Z|$ : Z is impedance per unit length of the

51

transmission line, and $|Z|$ is the absolute value of Z per unit length of the transmission line and represented by $\sqrt{r^2 + x^2}$ ,

r: a resistance component per unit length of the transmission line,

x: a reactance component per unit length of the transmission line,

$\alpha$: a line angle of the transmission line and a value represented by $\alpha = \tan^{-1}(\dfrac{x}{r})$,

$I_P$, $|I_P|$: a current flowing in said one end when a fault occurs and the absolute value thereof,

$V_P$, $|V_P|$: voltage at said one end when the fault occurs and the absolute value thereof,

$\lambda$: a value represented by $\alpha + \beta - \phi T$,

$\mu$: a value represented by $\theta + \beta - \phi T$,

$\beta$: a phase angle of $I_P$ based on $I_1$ ,

$I_1$: an incremental current generated when the fault occurs and represented by $I_P - I_{L1}$,

$I_{L1}$: a load current,

$\phi T$: an impedance angle of $Z_S + Z_P$ ,

$Z_S$: impedance when the other end is viewed from the junction at the system,

$Z_P$: the sum of impedance from said one end to the junction at the system and back impedance,

52

$\theta$: a phase angle of voltage $V_P$ based on $I_P$,

B: a reactance component from said one end to the other end, and

D: a resistance component from said one end to the other end.

Fig. 1
Prior Art

Fig. 2
Prior Art

Fig. 3

P END       Q END

$Z_{gP}$   $I = I_L + I_I$   $\ell Z$   $(L-\ell)Z$   $Z_{gQ}$

1−P    $I_1$    $I_2$    1−Q

$E_P$   V   FL   $R_F$   $V_F = R_F I_F$   $E_Q$

0239268

3/8

Fig. 4

Fig. 5

Fig. 6(a)

$$I = I_L + I_1$$

$Z_{gP} \longrightarrow$   $\ell_z$     $(L-\ell)Z$    $Z_{gQ}$

$I_1 \downarrow$   $\downarrow I_2$

$R_F$

$E_P$     $E_Q$

Fig. 6 (b)

$Z_{gP}$    $\ell_z$     $(L-\ell)Z$    $Z_{gQ}$

$IL$

$R_F$

$e$

$E_P$     $E_Q$

Fig. 6 (c)

$Z_{gP}$    $\ell_z$     $(L-\ell)Z$    $Z_{gQ}$

$R_F$

$I_1 \downarrow$   $\downarrow I_2$

$e$

Fig. 7

Fig. 8 (a)

Fig. 8 (b)

Fig. 8 (c)

Fig. 8 (d)

Fig. 9

Fig. 11

Fig. 10 (a)

Fig. 10 (b)

Fig. 10 (c)